# EUROPEAN PATENT SPECIFICATION

(11) **EP 1 208 612 B1**
(45) Date of publication and mention of the grant of the patent: **12.01.2011**
(21) Application number: 00959768.3
(22) Date of filing: 31.08.2000
(51) Int. Cl.: H01L 51/40

(54) **METHOD FOR FORMING A PATTERNED SEMICONDUCTOR FILM**
METHODE ZUR HERSTELLUNG EINES STRUKTURIERTEN HALBLEITERFILMS
PROCEDE DE FORMATION D'UN FILM SEMI-CONDUCTEUR A MOTIFS

(30) Priority: 31.08.1999 US 151715 P; 31.08.1999 US 151716 P; 21.07.2000 US 621000
(43) Date of publication of application: 29.05.2002
(73) Proprietor: E Ink Corporation, Cambridge, MA 02138 (US)
(72) Inventor: AMUNDSON, Karl, Cambridge, MA 02138 (US); DRZAIC, Paul, S., Lexington, MA 02421 (US); WANG, Jianna, Waltham, MA 02452 (US); DUTHALER, Gregg, Brookline, MA 02446 (US); KAZLAS, Peter, Sudbury, MA 01776 (US)
(74) Representative: Cole, David John
(86) International application number: PCT/US2000/024091
(87) International publication number: WO 2001/017041

(56) References cited:
- EP-A- 0 930 641
- WO-A-99/10939
- GB-A- 2 330 451
- HEBNER T R ET AL: "INK-JET PRINTING OF DOPED POLYMERS FOR ORGANIC LIGHT EMITTING DEVICES" APPLIED PHYSICS LETTERS,AMERICAN INSTITUTE OF PHYSICS. NEW YORK,US, vol. 72, no. 5, 2 February 1998 (1998-02-02), pages 519-521, XP000737411 ISSN: 0003-6951
- STURM J C ET AL: "PRINTING APPROACHES FOR LARGE-AREA COLOR ORGANIC LED DISPLAYS" PROCEEDINGS OF THE SPIE, SPIE, US LNKD- DOI:10.1117/12.372719, vol. 3797, 19 July 1999 (1999-07-19), pages 266-274, XP001032492 ISSN: 0277-786X
- STURM J.C. ET AL: 'Printing approaches for large-area color organic LED displays' PROCEEDINGS OF THE SPIE vol. 3797, July 1999, pages 266 - 274
- SZE S.M.: 'Semiconductor devices', 1985, JOHN WILEY & SONS * page 441; figure 11 *

## Description

The invention relates generally to manufacturing of semiconductor devices and more particularly to the patterning of semiconductor films in the manufacture of arrays of transistors for use in display devices.

The fabrication of all-printed backplanes on polymeric substrates through use of solvent-based inks offers the potential for lower cost, flexible, or large area displays. There are numerous potential applications for such displays, such as rolled displays, affordable large area displays, displays incorporated into fabrics, and as a paper substitute. Unfortunately, many problems remain in the development of thin-film transistor ("TFT") arrays used for addressing in such displays.

Organic semiconductor materials or dispersions of inorganic semiconducting particles lend themselves to relatively simple and inexpensive deposition methods. Possible methods include thermal evaporation in a vacuum chamber or wet processing such as spin coating using an appropriate solvent or by other coating techniques known to yield thin films.

Some deposition techniques have the advantage of forming thin films of organic semiconductor that have desirable properties such as a high field effect mobility for the dominant charge carrier in the films. For example, it is known that vacuum deposition of oligothiophenes such as α-sexithiophene, or α,ω-dihexyl quaterthiophene under proper processing conditions, gives films that exhibit a high field effect mobility.

Unfortunately, wet deposition processes do not readily permit patterning of the film because the wet material is generally distributed over the entire substrate. Vacuum deposition can be done in a patterned way using, for example, of a contact mask. Fine details, however, are difficult to pattern because of resolution limits of contact masks for vacuum deposition. Well established silicon-based device patterning methods, such as photolithography, are relatively complex and expensive. Such patterning methods conflict with the desire to manufacture relatively inexpensive arrays of transistors.

J.C. Sturm et al., Proceedings of the SPIE, vol. 3797, p. 266, 1999 discloses a method of patterning a polymer layer by ink-jet printing of fluorescent dyes to local areas of the polymer film.

What are needed are relatively simple, low cost manufacturing methods for production of patterned semiconductor films to help realize the advantages of large array and flexible displays.

The present invention provides a method to pattern semiconductor layers, in particular for use in the manufacture of lower cost, larger area transistor arrays. Use of lower cost deposition methods, such as printing techniques, enables realization of the benefits of large area displays, in particular displays employing an encapsulated electrophoretic display medium.

The present invention provides a process for forming a pattern in an organic semiconductor film disposed on a substrate. In this process, through a printing or stamping process a solvent is provided in contact with selected portions of the organic semiconductor film, the solvent dissolving the selected portions of the organic semiconductor film, and the solvent being evaporated after dissolving the selected portions of the organic semiconductor film such that the property of the selected portions differs from that of the remaining portions of the organic semiconductor film.

The solvent can be used with a gelling agent. The gelling agent assists, for example, in deposition of the solvent via printing methods.

The invention can assist all-printed fabrication of display devices. Patterning of the semiconductor layer can be accomplished through use of techniques such as silk screening or stamping. The invention has particular application in the fabrication of large area, flexible lower cost displays that incorporate a microencapsulated electrophoretic display medium.

The invention, in accordance with preferred and exemplary embodiments, together with further advantages thereof, is more particularly described in the following detailed description, taken in conjunction with the accompanying drawings.

In the drawings, like reference characters generally refer to the same parts throughout the different views. Also, the drawings are not necessarily to scale, emphasis instead generally being placed upon illustrating principles of the invention.
Figure 1 shows cross-sectional views of an embodiment of an electronic device at various stages of fabrication.
Figure 2a shows a cross-sectional view of an electronic device at an intermediate stage of fabrication that employs screen printing of a solvent.
Figure 2b shows a cross-sectional view of an electronic device at an intermediate stage of fabrication that employs stamping of a solvent.
Figure 3 shows a cross-sectional view of a display device that utilizes an TFT array fabricated with the process corresponding to the embodiment depicted in Figure 1.

The present invention relates generally to a method to pattern semiconductor layers, in particular for use in the manufacture of lower cost, large area transistor arrays. The invention is of particular use in the production of displays with a microencapsulated electrophoretic display medium and mitigates the problem of patterning semiconductor films to reduce leakage currents between neighboring TFT's, in particular those comprising an organic semiconductor film.

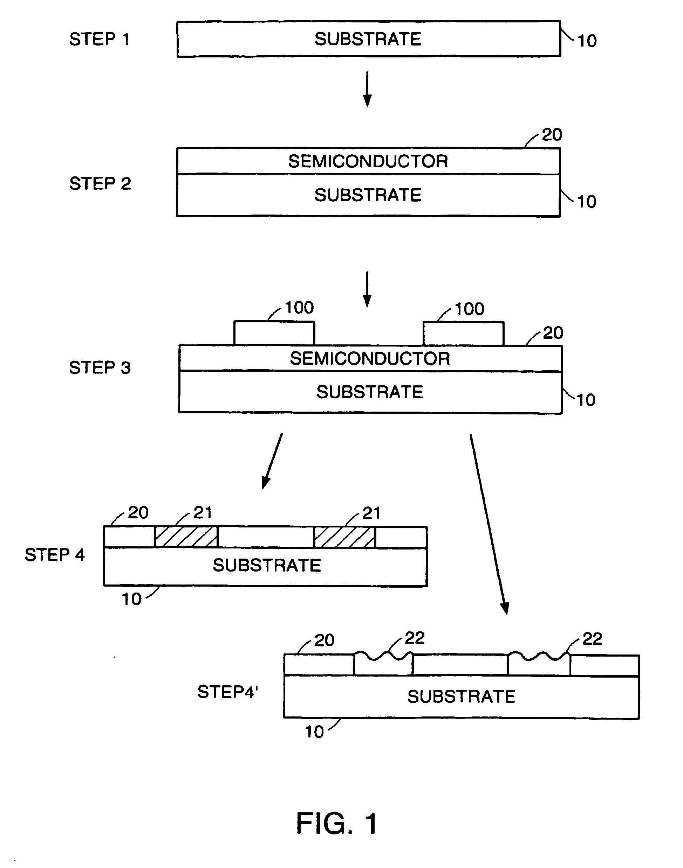

Referring to Figure 1, two embodiments of a method of patterning an organic semiconductor film 20 are depicted. A substrate 10 is provided (Step 1), comprised of, for example, a silicon wafer, a polyimide sheet or other polymer sheet. The organic semiconductor film 20 is deposited on the substrate 10 (Step 2). The film 20 comprises, for example, poly (alkyl thiophene), or precursors of pentacene and polythienylenevinylene (PTV), which can be converted into pentacene and PTV semiconductor at elevated temperature. Next, a patterned layer of a solvent I00 is deposited adjacent to the organic semiconductor film 20 (Step 3).

The solvent 100 is selected for its ability to dissolve the organic semiconductor film 20.

In preferred embodiments, an electrical property of the organic semiconductor film 20 is changed. The solvent 100 diminishes, for example, the conductivity of the organic semiconductor film 20 in portions that are adjacent to the solvent 100. This provides for reduced leakage currents between unaffected portions of the organic semiconductor 125 film 20 which can be used for fabrication of organic TFT's ("OTFT").

The solvent can comprise chloroform, toluene, or xylene if the organic semiconductor film 20 comprises poly (alkylthiophene). In this case, adjacent organic semiconductor film 20 material dissolves and redeposits as the solvent dries (Step 4'). This leaves damaged material 22 that has undergone 135 gross morphological changes, typically behaving now as an insulator.

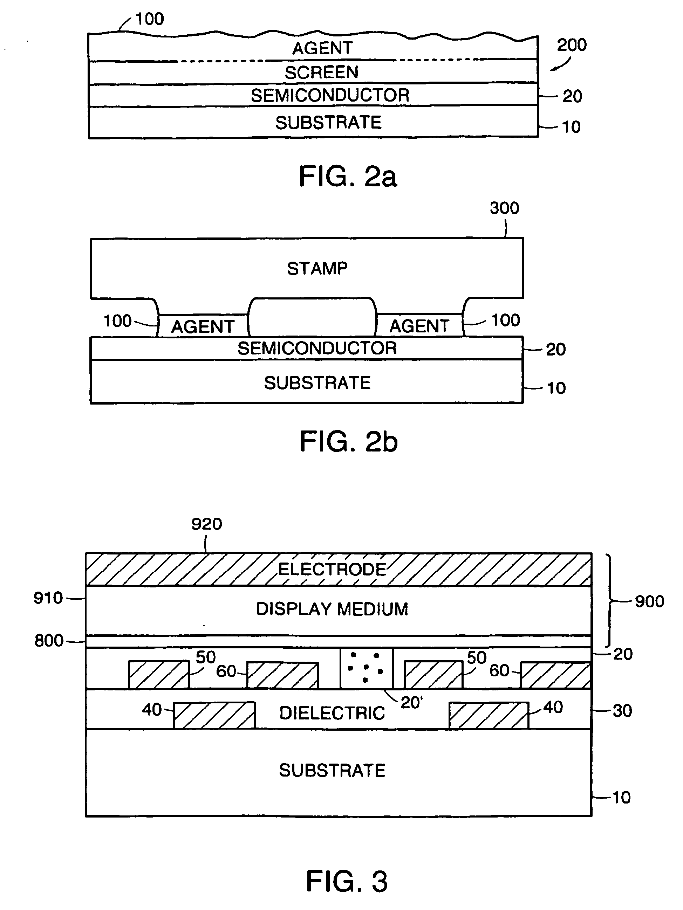

Now referring to Figure 2a and 2b, the solvent 100 can be deposited on the organic semiconductor film 20 via various methods. In some preferred embodiments, low cost methods are employed to deposit a patterned film of the solvent 100 onto the organic semiconductor film 20. Portions of the organic semiconductor film 20 that are in direct contact 140 with the solvent 100 will have their properties damaged.

In one embodiment, a screen 200 is used for patterned deposition of the solvent on the organic semiconductor film 20. In another embodiment, a stamp 300 provides patterned deposition of the solvent 100. For example, pentacene precursor is soluble in dichloromethane, when an rubber stamp wetted with dichloromethane is brought into contact 145 with pentacene precursor, it partially dissolves the pentacene precursor, therefore, a patterned pentacene can be obtained upon thermal conversion. Other relatively low cost deposition methods can serve to deposit the solvent 100, for example, printing processes such as ink jet printing, electrostatic printing processes, and thermal printing.

To assist in the deposition process and control of the sovent 100, it can be used with a gelling agent. The rheological properties imparted by the gelling agent aid selective placement of the solvent. The gelling agent can comprise a soluble polymer or a substance that forms extended aggregates.

After a gel-based agent 100 comprising a solvent dissolves neighboring portions of the organic semiconductor film 20, the solvent can then be allowed to dry at ambient temperature or with the application of heat or decreased pressure. The formerly dissolved portions of the organic semiconductor film 20 redeposit in combination with the gelling agent, leaving damaged material 22 with gross morphological changes, typically with no remaining semiconducting properties.

Fabrication of displays devices such as liquid crystal or electrophoretic displays, in particular microencapsulated electrophoretic displays, can utilize the above method during fabrication of arrays of OTFT's for addressing the display medium. Referring to Figure 3, an embodiment of an electrophoretic display device comprises: a substrate 10, for example a silicon wafer ; a gate electrode 40, for example, heavily doped silicon; a dielectric layer 30, for example, 180 silicon dioxide; source 50 and drain 60 electrodes, for example gold; an organic semiconductor film 20, for example poly (alkylthiophene), pentacene, alpha-sexithiophene, or copper phthalocyanine ("CuPc"), an electrophoretic display medium assembly 900 comprising an electrophoretic display medium 910 and a top electrode 920; and a lamination adhesive 800, for example a water-based polyurethane emulsion, where the lamination adhesive is used to attach 185 the display medium assembly 900 to the organic semiconductor film 20 and other portions of the OTFT. In particular, damaged material 21'in portions of the organic semiconductor film provide electrical isolation between individual transistors in the OTFT array.

In some embodiments, the array of OTFT's is first separately manufactured from the manufacture of the electrophoretic display medium assembly 900. The display medium assembly 900 is comprised, for example, of a microencapsulated electrophoretic display medium printed onto an indium tin oxide ("ITO") coated glass plate. The OTFT array is then bonded, in this embodiment, to the display medium assembly 900 with the lamination adhesive 800.

### Method Of Manufacturing An Electrophoretic Display Assembly

In a preferred embodiment, an encapsulated electrophoretic display assembly is manufactured with use of printing or coating steps on a wide variety of flexible substrates. As used herein, the term "printing" includes all forms of printing and coating, including, but not limited to, pre-metered coatings such as patch die coating, slot or extrusion coating, slide or cascade coating, and curtain coating: roll coating such as knife over roll coating, forward and reverse roll coating, gravure coating, dip coating, spray coating, meniscus coating, spin coating, brush coating, air knife coating, silk screen printing processes, electrostatic printing processes, thermal printing processes, ink jet printing processes and other similar techniques. Thus, the resulting display can be flexible. Further, because the display medium can be printed (using a variety of methods), the display itself can be made inexpensively.

Further, printing methods can be used to form the electrical connections and other conductive portions of a display A rear conductor ("rear" referring to a side of a display that is opposite to that viewed by a user) can be either opaque or transparent. This allows the use of a variety of printed rear conductors, including graphite inks, silver inks, or conductive polymers.

The front conductor ("front" referring to a side of a display that is viewed by a user) must be transparent, but need not have excellent conductivity. Even materials with relatively poor conductivity, though amenable to printing, can be employed, for example conductive colloidal suspensions and conductive polymers such as are commonly used in anti-static applications.

A microencapsulated electrophoretic medium, unlike a liquid crystal medium, is amenable to use with a wide number of intrinsically conductive polymer systems, including derivatives of polyaniline, polypyrrole, polythiophene, and polyphenylenevinylene.

In short, the present invention permits a more advantageous use of cost savings allowed by use of printing methods for formation of conducting materials in a display assembly.

The following describes in detail various embodiments of materials with applications to the electrophoretic display medium.

### Materials for Use in Electrophoretic Displays

Useful materials for constructing the above-described encapsulated electrophoretic displays are discussed in detail below. Many of these materials will be known to those skilled in the art of constructing conventional electrophoretic displays, or those skilled in the art of microencapsulation.

### A. Particles

There is much flexibility in the choice of particles for use in electrophoretic displays, as described above. For purposes of this invention, a particle is any component that is charged or capable of acquiring a charge (*i. e.,* has or is capable of acquiring electrophoretic mobility), and, in some cases, this mobility may be zero or close to zero (*i. e.,* the particles will not move). The particles may be neat pigments, dyed (laked) pigments or pigment/polymer composites, or any other component that is charged or capable of acquiring a charge. Typical considerations for the electrophoretic particle are its optical properties, electrical properties, and surface chemistry. The particles may be organic or inorganic compounds, and they may either absorb light or scatter light. The particles for use in the invention may further include scattering pigments, absorbing pigments and luminescent particles. The particles may be retroreflective, such as corner cubes, or they may be electroluminescent, such as zinc sulfide particles, which emit light when excited by an AC field, or they may be photoluminescent. Finally, the particles may be surface treated so as to improve charging or interaction with a charging agent, or to improve dispersibility.

A preferred particle for use in electrophoretic displays of the invention is titania. The titania particles may be coated with a metal oxide, such as aluminum oxide or silicon oxide, for example. The titania particles may have one, two, or more layers of metal-oxide coating. For example, a titania particle for use in electrophoretic displays of the invention may have a coating of aluminum oxide and a coating of silicon oxide. The coatings may be added to the particle in any order.

The electrophoretic particle is usually a pigment, a polymer, a laked pigment, or some combination of the above. A neat pigment can be any pigment, and, usually for a light colored particle, pigments such as, for example, rutile (titania), anatase (titania), barium sulfate, kaolin, or zinc oxide are useful. Some typical particles have high refractive indices, high scattering coefficients, and low absorption coefficients. Other particles are absorptive, such as carbon black or colored pigments used in paints and inks. The pigment should also be insoluble in the suspending fluid. Yellow pigments such as diarylide yellow, hansa yellow, and benzidin yellow have also found use in similar displays. Any other reflective material can be employed for a light colored particle, including non-pigment materials, such as metallic particles.

Useful neat pigments include, but are not limited to, PbCrO₄, Cyan blue GT 55-3295 (American Cyanamid Company, Wayne, NJ), Cibacron Black BG (Ciba Company, Inc., Newport, DE), Cibacron Turquoise Blue G (Ciba), Cibalon Black-BGL (Ciba), Orasol Black BRG (Ciba), Orasol Black RBL (Ciba), Acetamine Blac, CBS (E. I. du Pont de Nemours and Company, Inc., Wilmington, DE), Crocein Scarlet N Ex (du Pont) (27290), Fiber Black VF (DuPont) (30235), Luxol Fast Black L (DuPont) (Solv. Black 17), Nirosine Base No. 424 (DuPont) (50415 B), Oil Black BG (DuPont) (Solv. Black 16), Rotalin Black RM (DuPont), Sevron Brilliant Red 3 B (DuPont); Basic Black-DSC (Dye Specialties, Inc.), Hectolene Black (Dye Specialties, Inc.), Azosol Brilliant Blue B (GAF, Dyestuff and Chemical Division, Wayne, NJ) (Solv. Blue 9), Azosol Brilliant Green BA (GAF) (Solv. Green 2), Azosol Fast Brilliant Red B (GAF), Azosol Fast Orange RA Conc. (GAF) (Solv. Orange 20), Azosol Fast Yellow GRA Conc. (GAF) (13900 A), Basic Black KMPA (GAF), Benzofix Black CW-CF (GAF) (35435), Cellitazol BNFV Ex Soluble CF (GAF) (Disp. Black 9), Celliton Fast Blue AF Ex Conc (GAF) (Disp. Blue 9), Cyper Black IA (GAF) (Basic Blk. 3), Diamine Black CAP Ex Conc (GAF) (30235), Diamond Black EAN Hi Con. CF (GAF) (15710), Diamond Black PBBA Ex (GAF) (16505); Direct Deep Black EA Ex CF (GAF) (30235), Hansa Yellow G (GAF) (11680); Indanthrene Black BBK Powd. (GAF) (59850), Indocarbon CLGS Conc. CF (GAF) (53295), Katigen Deep Black NND Hi Conc. CF (GAF) (15711), Rapidogen Black 3 G (GAF) (Azoic Blk. 4); Sulphone Cyanine Black BA-CF (GAF) (26370), Zambezi Black VD Ex Conc. (GAF) (30015); Rubanox Red CP-1495 (The Sherwin-Williams Company, Cleveland, OH) (15630); Raven 11 (Columbian Carbon Company, Atlanta, GA), (carbon black aggregates with a particle size of about 25 µm), Statex B-12 (Columbian Carbon Co.) (a furnace black of 33 µm average particle size), and chrome green.

Particles may also include laked, or dyed, pigments. Laked pigments are particles that have a dye precipitated on them or which are stained. Lakes are metal salts of readily soluble anionic dyes. These are dyes of azo, triphenylmethane or anthraquinone structure containing one or more sulphonic or carboxylic acid groupings. They are usually precipitated by a calcium, barium or aluminum salt onto a substrate. Typical examples are peacock blue lake (CI Pigment Blue 24) and Persian orange (lake of CI Acid Orange 7), Black M Toner (GAF) (a mixture of carbon black and black dye precipitated on a lake).

A dark particle of the dyed type may be constructed from any light absorbing material, such as carbon black, or inorganic black materials. The dark material may also be selectively absorbing. For example, a dark green pigment may be used. Black particles may also be formed by staining latices with metal oxides, such latex copolymers consisting of any of butadiene, styrene, isoprene, methacrylic acid, methyl methacrylate, acrylonitrile, vinyl chloride, acrylic acid, sodium styrene sulfonate, vinyl acetate, chlorostyrene, dimethylaminopropylmethacrylamide, isocyanoethyl methacrylate and N-(isobutoxymethacrylamide), and optionally including conjugated diene compounds such as diacrylate, triacrylate, dimethylacrylate and trimethacrylate. Black particles may also be formed by a dispersion polymerization technique.

In the systems containing pigments and polymers, the pigments and polymers may form multiple domains within the electrophoretic particle, or be aggregates of smaller pigment/polymer combined particles. Alternatively, a central pigment core may be surrounded by a polymer shell. The pigment, polymer, or both can contain a dye. The optical purpose of the particle may be to scatter light, absorb light, or both. Useful sizes may range from 1 nm up to about 100 µm, as long as the particles are smaller than the bounding capsule. In a preferred embodiment, the density of the electrophoretic particle may be substantially matched to that of the suspending (*i.e*., electrophoretic) fluid. As defined herein, a suspending fluid has a density that is "substantially matched" to the density of the particle if the difference in their respective densities is between about zero and about two g/ml. This difference is preferably between about zero and about 0.5 g/ml.

Useful polymers for the particles include, but are not limited to: polystyrene, polyethylene, polypropylene, phenolic resins, Du Pont Elvax resins (ethylene-vinyl acetate copolymers), polyesters, polyacrylates, polymethacrylates, ethylene acrylic acid or methacrylic acid copolymers (Nucrel Resins - DuPont, Primacor Resins- Dow Chemical), acrylic copolymers and terpolymers (Elvacite Resins, DuPont) and PMMA. Useful materials for homopolymer / pigment phase separation in high shear melt include, but are not limited to, polyethylene, polypropylene, polymethylmethacrylate, polyisobutylmethacrylate, polystyrene, polybutadiene, polyisoprene, polyisobutylene, polylauryl methacrylate, polystearyl methacrylate, polyisobornyl methacrylate, poly-t-butyl methacrylate, polyethyl methacrylate, polymethyl acrylate, polyethyl acrylate, polyacrylonitrile, and copolymers of two or more of these materials. Some useful pigment/polymer complexes that are commercially available include, but are not limited to, Process Magenta PM 1776 (Magruder Color Company, Inc., Elizabeth, NJ), Methyl Violet PMA VM6223 (Magruder Color Company, Inc., Elizabeth, NJ), and Naphthol FGR RF6257 (Magruder Color Company, Inc., Elizabeth, NJ).

The pigment-polymer composite may be formed by a physical process, (*e.g*., attrition or ball milling), a chemical process (*e.g*., microencapsulation or dispersion polymerization), or any other process known in the art of particle production. From the following non-limiting examples, it may be seen that the processes and materials for both the fabrication of particles and the charging thereof are generally derived from the art of liquid toner, or liquid immersion development. Thus any of the known processes from liquid development are particularly, but not exclusively, relevant.

New and useful electrophoretic particles may still be discovered, but a number of particles already known to those skilled in the art of electrophoretic displays and liquid toners can also prove useful. In general, the polymer requirements for liquid toners and encapsulated electrophoretic inks are similar, in that the pigment or dye must be easily incorporated therein, either by a physical, chemical, or physicochemical process, may aid in the colloidal stability, and may contain charging sites or may be able to incorporate materials which contain charging sites. One general requirement from the liquid toner industry that is not shared by encapsulated electrophoretic inks is that the toner must be capable of "fixing" the image, *i.e*., heat fusing together to create a uniform film after the deposition of the toner particles.

Typical manufacturing techniques for particles are drawn from the liquid toner and other arts and include ball milling, attrition, jet milling, etc. The process will be illustrated for the case of a pigmented polymeric particle. In such a case the pigment is compounded in the polymer, usually in some kind of high shear mechanism such as a screw extruder. The composite material is then (wet or dry) ground to a starting size of around 10 µm. It is then dispersed in a carrier liquid, for example ISOPAR^{®} (Exxon, Houston, TX), optionally with some charge control agent(s), and milled under high shear for several hours down to a final particle size and/or size distribution.

Another manufacturing technique for particles drawn from the liquid toner field is to add the polymer, pigment, and suspending fluid to a media mill. The mill is started and simultaneously heated to temperature at which the polymer swells substantially with the solvent. This temperature is typically near 100°C. In this state, the pigment is easily encapsulated into the swollen polymer. After a suitable time, typically a few hours, the mill is gradually cooled back to ambient temperature while stirring. The milling may be continued for some time to achieve a small enough particle size, typically a few microns in diameter. The charging agents may be added at this time. Optionally, more suspending fluid may be added.

Chemical processes such as dispersion polymerization, mini- or micro-emulsion polymerization, suspension polymerization precipitation, phase separation, solvent evaporation, *in situ* polymerization, seeded emulsion polymerization, or any process which falls under the general category of microencapsulation may be used. A typical process of this type is a phase separation process wherein a dissolved polymeric material is precipitated out of solution onto a dispersed pigment surface through solvent dilution, evaporation, or a thermal change. Other processes include chemical means for staining polymeric latices, for example with metal oxides or dyes.

### B. Suspending Fluid

The suspending fluid containing the particles can be chosen based on properties such as density, refractive index, and solubility. A preferred suspending fluid has a low dielectric constant (about 2), high volume resistivity (about 10^15 ohm-cm), low viscosity (less than 5 cst), low toxicity and environmental impact, low water solubility (less than 10 ppm), high specific gravity (greater than 1.5), a high boiling point (greater than 90°C), and a low refractive index (less than 1.2).

The choice of suspending fluid may be based on concerns of chemical inertness, density matching to the electrophoretic particle, or chemical compatibility with both the electrophoretic particle and bounding capsule. The viscosity of the fluid should be low when you want the particles to move. The refractive index of the suspending fluid may also be substantially matched to that of the particles. As used herein, the refractive index of a suspending fluid "is substantially matched" to that of a particle if the difference between their respective refractive indices is between about zero and about 0.3, and is preferably between about 0.05 and about 0.2.

Additionally, the fluid may be chosen to be a poor solvent for some polymers, which is advantageous for use in the fabrication of microparticles because it increases the range of polymeric materials useful in fabricating particles of polymers and pigments. Organic solvents, such as halogenated organic solvents, saturated linear or branched hydrocarbons, silicone oils, and low molecular weight halogen-containing polymers are some useful suspending fluids. The suspending fluid may comprise a single fluid. The fluid will, however, often be a blend of more than one fluid in order to tune its chemical and physical properties. Furthermore, the fluid may contain surface modifiers to modify the surface energy or charge of the electrophoretic particle or bounding capsule. Reactants or solvents for the microencapsulation process (oil soluble monomers, for example) can also be contained in the suspending fluid. Charge control agents can also be added to the suspending fluid.

Useful organic solvents include, but are not limited to, epoxides, such as, for example, decane epoxide and dodecane epoxide; vinyl ethers, such as, for example, cyclohexyl vinyl ether and Decave^{®} (International Flavors & Fragrances, Inc., New York, NY); and aromatic hydrocarbons, such as, for example, toluene and naphthalene. Useful halogenated organic solvents include, but are not limited to, tetrafluorodibromoethylene, tetrachloroethylene, trifluorochloroethylene, 1,2.4-trichlorobenzene, carbon tetrachloride. These materials have high densities. Useful hydrocarbons include, but are not limited to, dodecane, tetradecane, the aliphatic hydrocarbons in the Isopar^{®} series (Exxon, Houston, TX), Norpar^{®} (series of normal paraffinic liquids), Shell-Sol^{®} (Shell, Houston, TX), and Sol-Trol^{®} (Shell), naphtha, and other petroleum solvents. These materials usually have low densities. Useful examples of silicone oils include, but are not limited to, octamethyl cyclosiloxane and higher molecular weight cyclic siloxanes, poly (methyl phenyl siloxane), hexamethyldisiloxane, and polydimethylsiloxane. These materials usually have low densities. Useful low molecular weight halogen-containing polymers include, but are not limited to, poly(chlorotrifluoroethylene) polymer (Halogenated hydrocarbon Inc., River Edge, NJ). Gaiden^{®} (a perfluorinated ether from Ausimont, Morristown, NJ), or Krytox^{®} from DuPont (Wilmington, DE). In a preferred embodiment, the suspending fluid is a poly(chlorotrifluoroethylene) polymer. In a particularly preferred embodiment, this polymer has a degree of polymerization from about 2 to about 10. Many of the above materials are available in a range of viscosities, densities, and boiling points.

The fluid must be capable of being formed into small droplets prior to a capsule being formed. Processes for forming small droplets include flow-through jets, membranes, nozzles, or orifices, as well as shear-based emulsifying schemes. The formation of small drops may be assisted by electrical or sonic fields. Surfactants and polymers can be used to aid in the stabilization and emulsification of the droplets in the case of an emulsion type encapsulation. A preferred surfactant for use in displays of the invention is sodium dodecylsulfate.

It can be advantageous in some displays for the suspending fluid to contain an optically absorbing dye. This dye must be soluble in the fluid, but will generally be insoluble in the other components of the capsule. There is much flexibility in the choice of dye material. The dye can be a pure compound, or blends of dyes to achieve a particular color, including black. The dyes can be fluorescent, which would produce a display in which the fluorescence properties depend on the position of the particles. The dyes can be photoactive, changing to another color or becoming colorless upon irradiation with either visible or ultraviolet light, providing another means for obtaining an optical response. Dyes could also be polymerizable, forming a solid absorbing polymer inside the bounding shell.

There are many dyes that can be chosen for use in encapsulated electrophoretic display. Properties important here include light fastness, solubility in the suspending liquid, color, and cost. These are generally from the class of azo, anthraquinone, and triphenylmethane type dyes and may be chemically modified so as to increase the solubility in the oil phase and reduce the adsorption by the particle surface.

A number of dyes already known to those skilled in the art of electrophoretic displays will prove useful. Useful azo dyes include, but are not limited to: the Oil Red dyes, and the Sudan Red and Sudan Black series of dyes. Useful anthraquinone dyes include, but are not limited to: the Oil Blue dyes, and the Macrolex Blue series of dyes. Useful triphenylmethane dyes include, but are not limited to, Michler's hydrol, Malachite Green, Crystal Violet, and Auramine O.

### C. Charge Control Agents and Particle Stabilizers

Charge control agents are used to provide good electrophoretic mobility to the electrophoretic particles. Stabilizers are used to prevent agglomeration of the electrophoretic particles, as well as prevent the electrophoretic particles from irreversibly depositing onto the capsule wall. Either component can be constructed from materials across a wide range of molecular weights (low molecular weight, oligomeric, or polymeric), and may be pure or a mixture. In particular, suitable charge control agents are generally adapted from the liquid toner art. The charge control agent used to modify and/or stabilize the particle surface charge is applied as generally known in the arts of liquid toners, electrophoretic displays, non-aqueous paint dispersions, and engine-oil additives. In all of these arts, charging species may be added to non-aqueous media in order to increase electrophoretic mobility or increase electrostatic stabilization. The materials can improve steric stabilization as well. Different theories of charging are postulated, including selective ion adsorption, proton transfer, and contact electrification.

An optional charge control agent or charge director may be used. These constituents typically consist of low molecular weight surfactants, polymeric agents, or blends of one or more components and serve to stabilize or otherwise modify the sign and/or magnitude of the charge on the electrophoretic particles. The charging properties of the pigment itself may be accounted for by taking into account the acidic or basic surface properties of the pigment, or the charging sites may take place on the carrier resin surface (if present), or a combination of the two. Additional pigment properties which may be relevant are the particle size distribution, the chemical composition, and the lightfastness. The charge control agent used to modify and/or stabilize the particle surface charge is applied as generally known in the arts of liquid toners, electrophoretic displays, non-aqueous paint dispersions, and engine-oil additives. In all of these arts, charging species may be added to non-aqueous media in order to increase electrophoretic mobility or increase electrostatic stabilization. The materials can improve steric stabilization as well. Different theories of charging are postulated, including selective ion adsorption, proton transfer, and contact electrification.

Charge adjuvants may also be added. These materials increase the effectiveness of the charge control agents or charge directors. The charge adjuvant may be a polyhydroxy compound or an aminoalcohol compound, which are preferably soluble in the suspending fluid in an amount of at least 2% by weight. Examples of polyhydroxy compounds which contain at least two hydroxyl groups include, but are not limited to, ethylene glycol, 2,4,7,9-tetramethyl-decyne-4,7-diol, poly (propylene glycol), pentaethylene glycol, tripropylene glycol, triethylene glycol, 535 glycerol, pentaerythritol, glycerol tris (12-hydroxystearate), propylene glycerol monohydroxystearate, and ethylene glycol monohydroxystearate. Examples of aminoalcohol compounds which contain at least one alcohol function and one amine function in the same molecule include, but are not limited to, triisopropanolamine, triethanolamine, ethanolamine, 3-amino-1-propanol, o-aminophenol, 5-amino-1-pentanol, and *tetrakis*(2-hydroxyethyl)ethylenediamine. The charge adjuvant is preferably present in the suspending fluid in an amount of about 1 to about 100 mg/g of the particle mass, and more preferably about 50 to about 200 mg/g.

The surface of the particle may also be chemically modified to aid dispersion, to improve surface charge, and to improve the stability of the dispersion, for example. Surface modifiers include organic siloxanes, organohalogen silanes and other functional silane coupling agents (Dow Corning's^{®} Z-6070, Z-6124, and 3 additive, Midland, MI); organic titanates and zirconates (Tyzor^{®} TOT, TBT, and TE Series, DuPont, Wilmington, DE); hydrophobing agents, such as long chain (C12 to C50) alkyl and alkyl benzene sulphonic acids, fatty amines or diamines and their salts or quaternary derivatives; and amphipathic polymers which can be covalently bonded to the particle surface.

In general, it is believed that charging results as an acid-base reaction between some moiety present in the continuous phase and the particle surface. Thus useful materials are those which are capable of participating in such a reaction, or any other charging reaction as known in the art.

Different non-limiting classes of charge control agents which are useful include organic sulfates or sulfonates, metal soaps, block or comb copolymers, organic amides, organic zwitterions, and organic phosphates and phosphonates. Useful organic sulfates and sulfonates include, but are not limited to, sodium bis (2-ethyl hexyl) sulfosuccinate, calcium dodecyl benzene sulfonate, calcium petroleum sulfonate, neutral or basic barium dinonylnaphthalene sulfonate, neutral or basic calcium dinonylnaphthalene sulfonate, dodecylbenzenesulfonic acid sodium salt, and ammonium lauryl sulphate. Useful metal soaps include, but are not limited to, basic or neutral barium petronate, calcium petronate, Co-, Ca-, Cu-, Mn-, Ni-, Zn-, and Fe- salts of naphthenic acid, Ba-, Al-, Zn-, Cu-, Pb-, and Fe- salts of stearic acid, divalent and trivalent metal carboxylates, such as aluminum tristearate, aluminum octanoate, lithium heptanoate, iron stearate, iron distearate, barium stearate, chromium stearate, magnesium octanoate, calcium stearate, iron naphthenate, and zinc naphthenate, Mn- and Zn- heptanoate, and Ba-, Al-, Co-, Mn-, and Zn- octanoate. Useful block or comb copolymers include, but are not limited to, AB diblock copolymers of (A) polymers of 2-(N,N)-dimethylaminoethyl methacrylate quaternized with methyl-p-toluenesulfonate and (B) poly-2-ethylhexyl methacrylate, and comb graft copolymers with oil soluble tails of poly (12-hydroxystearic acid) and having a molecular weight of about 1800, pendant on an oil-soluble anchor group of poly (methyl methacrylate-methacrylic acid). Useful organic amides include, but are not limited to, polyisobutylene succinimides such as OLOA 371 and 1200, and N-vinyl pyrrolidone polymers. Useful organic zwitterions include, but are not limited to, lecithin. Useful organic phosphates and phosphonates include, but are not limited to, the sodium salts of phosphated mono- and di-glycerides with saturated and unsaturated acid substituents.

Particle dispersion stabilizes may be added to prevent particle flocculation or attachment to the capsule walls. For the typical high resistivity liquids used as suspending fluids in electrophoretic displays, nonaqueous surfactants may be used. These include, but are not limited to, glycol ethers, acetylenic glycols, alkanolamides, sorbitol derivatives, alkyl amines, quaternary amines, imidazolines, dialkyl oxides, and sulfosuccinates.

### D. Encapsulation

There is a long and rich history to encapsulation, with numerous processes and polymers having proven useful in creating capsules. Encapsulation of the internal phase may be accomplished in a number of different ways. Numerous suitable procedures for microencapsulation are detailed in both Microencapsulation, Processes and Applications, (I. E. Vandegaer, ed.), Plenum Press, New York, NY (1974) and Gutcho, Microcapsules and Microencapsulation Techniques, Nuyes Data Corp., Park Ridge, N. J. (1976). The processes fall into several general categories, all of which can be applied to the present invention: interfacial polymerization, *in situ* polymerization, physical processes, such as coextrusion and other phase separation processes, in-liquid curing, and simple/complex coacervation.

Numerous materials and processes should prove useful in formulating displays of the present invention. Useful materials for simple coacervation processes include, but are not limited to, gelatin, polyvinyl alcohol, polyvinyl acetate, and cellulosic derivatives, such as, for example, carboxymethylcellulose. Useful materials for complex coacervation processes include, but are not limited to, gelatin, acacia, carageenan, carboxymethylcellulose, hydrolyzed styrene anhydride copolymers, agar, alginate, casein, albumin, methyl vinyl ether co-maleic anhydride, and cellulose phthalate. Useful materials for phase separation processes include, but are not limited to, polystyrene, PMMA, polyethyl methacrylate, polybutyl methacrylate, ethyl cellulose, polyvinyl pyridine, and poly acrylonitrile. Useful materials for in situ polymerization processes include, but are not limited to, polyhydroxyamides, with aldehydes, melamine, or urea and formaldehyde; water-soluble oligomers of the condensate of melamine, or urea and formaldehyde; and vinyl monomers, such as, for example, styrene, MMA and acrylonitrile. Finally, useful materials for interfacial polymerization processes include, but are not limited to, diacyl chlorides, such as, for example, sebacoyl, adipoyl, and di-or poly-amines or alcohols, and isocyanates. Useful emulsion polymerization materials may include, but are not limited to, styrene, vinyl acetate, acrylic acid, butyl acrylate, t-butyl acrylate, methyl methacrylate, and butyl methacrylate.

Capsules produced may be dispersed into a curable carrier, resulting in an ink which may be printed or coated on large and arbitrarily shaped or curved surfaces using conventional printing and coating techniques.

In the context of the present invention, one skilled in the art will select an encapsulation procedure and wall material based on the desired capsule properties. These properties include the distribution of capsule radii; electrical, mechanical, diffusion, and optical properties of the capsule wall; and chemical compatibility with the internal phase of the capsule.

The capsule wall generally has a high electrical resistivity. Although it is possible to use walls with relatively low resistivities, this may limit performance in requiring relatively higher addressing voltages. The capsule wall should also be mechanically strong (although if the finished capsule powder is to be dispersed in a curable polymeric binder for coating, mechanical strength is not as critical). The capsule wall should generally not be porous. If, however, it is desired to use an encapsulation procedure that produces porous capsules, these can be overcoated in a post-processing step (*i.e.,* a second encapsulation). Moreover, if the capsules are to be dispersed in a curable binder, the binder will serve to close the pores. The capsule walls should be optically clear. The wall material may, however, be chosen to match the refractive index of the internal phase of the capsule (*i.e*., the suspending fluid) or a binder in which the capsules are to be dispersed. For some applications (*e.g*., interposition between two fixed electrodes), monodispersed capsule radii are desirable.

An encapsulation procedure involves a polymerization between urea and formaldehyde in an aqueous phase of an oil/water emulsion in the presence of a negatively charged, carboxyl-substituted, linear hydrocarbon polyelectrolyte material. The resulting capsule wall is a urea/formaldehyde copolymer, which discretely encloses the internal phase. The capsule is clear, mechanically strong, and has good resistivity properties.

The related technique of *in situ* polymerization utilizes an oil/water emulsion, which is formed by dispersing the electrophoretic composition (*i.e*., the dielectric liquid containing a suspension of the pigment particles) in an aqueous environment. The monomers polymerize to form a polymer with higher affinity for the internal phase than for the aqueous phase, thus condensing around the emulsified oily droplets. In one especially useful *in situ* polymerization processes, urea and formaldehyde condense in the presence of poly(acrylic acid) (See, *e.g*., U.S. Patent No. 4,001,140). In other useful process, any of a variety of cross-linking agents borne in aqueous solution is deposited around microscopic oil droplets. Such cross-linking agents include aldehydes, especially formaldehyde, glyoxal, or glutaraldehyde; alum; zirconium salts; and poly isocyanates. The entire disclosures of the 4,001,140 and 4,273,672 patents are hereby incorporated by reference herein.

The coacervation approach also utilizes an oil/water emulsion. One or more colloids are coacervated (*i.e*., agglomerated) out of the aqueous phase and deposited as shells around the oily droplets through control of temperature pH and/or relative concentrations, thereby creating the microcapsule. Materials suitable for coacervation include gelatins and gum arabic.

The interfacial polymerization approach relies on the presence of an oil-soluble monomer in the electrophoretic composition, which once again is present as an emulsion in an aqueous phase. The monomers in the minute hydrophobic droplets react with a monomer introduced into the aqueous phase, polymerizing at the interface between the droplets and the surrounding aqueous medium and forming shells around the droplets. Although the resulting walls are relatively thin and may be permeable, this process does not require the elevated temperatures characteristic of some other processes, and therefore affords greater flexibility in terms of choosing the dielectric liquid.

Coating aids can be used to improve the uniformity and quality of the coated or printed electrophoretic ink material. Wetting agents are typically added to adjust the interfacial tension at the coating/substrate interface and to adjust the liquid/air surface tension. Wetting agents include, but are not limited to, anionic and cationic surfactants, and nonionic species, such as silicone or fluoropolymer based materials. Dispersing agents may be used to modify the interfacial tension between the capsules and binder, providing control over flocculation and particle settling.

Surface tension modifiers can be added to adjust the air/ink interfacial tension. Polysiloxanes are typically used in such an application to improve surface leveling while minimizing other defects within the coating. Surface tension modifiers include, but are not limited to, fluorinated surfactants, such as, for example, the Zonyl^{®} series from DuPont (Wilmington, DE), the Fluorod^{®} series from 3M (St. Paul, MN), and the fluoroakyl series from Autochem (Glen Rock, NJ); siloxanes, such as, for example, Silwet^{®} from Union Carbide (Danbury, CT); and polyethoxy and polypropoxy alcohols. Antifoams, such as silicone and silicone-free polymeric materials, may be added to enhance the movement of air from within the ink to the surface and to facilitate the rupture of bubbles at the coating surface. Other useful antifoams include, but are not limited to, glyceryl esters, polyhydric alcohols, compounded antifoams, such as oil solutions of alkyl benzenes, natural fats, fatty acids, and metallic soaps, and silicone antifoaming agents made from the combination of dimethyl siloxane polymers and silica. Stabilizers such as uv-absorbers and antioxidants may also be added to improve the lifetime of the ink.

Other additives to control properties like coating viscosity and foaming can also be used in the coating fluid. Stabilizers (UV-absorbers, antioxidants) and other additives which could prove useful in practical materials.

### E. Binder Material

The binder is used as a non-conducting, adhesive medium supporting and protecting the capsules, as well as binding the electrode materials to the capsule dispersion. Binders are available in many forms and chemical types. Among these are water-soluble polymers, water-borne polymers, oil-soluble polymers, thermoset and thermoplastic polymers, and radiation-cured polymers.

Among the water-soluble polymers are the various polysaccharides, the polyvinyl alcohols, N-methylpyrrolidone, N-vinylpyrrolidone, the various Carbowax^{®} species (Union Carbide, Danbury, CT), and poly-2-hydroxyethylacrylate.

The water-dispersed or water-borne systems are generally latex compositions, typified by the Neorez^{®} and Neocryl^{®} resins (Zeneca Resins, Wilmington, MA), Acrysol^{®} (Rohm and Haas, Philadelphia, PA), Bayhydrol^{®} (Bayer, Pittsburgh, PA), and the Cytec Industries (West Paterson, NJ) HP line. These are generally latices of polyurethanes, occasionally compounded with one or more of the acrylics, polyesters, polycarbonates or silicones, each lending the final cured resin in a specific set of properties defined by glass transition temperature, degree of "tack," softness, clarity, flexibility, water permeability and solvent resistance, elongation modulus and tensile strength, thermoplastic flow, and solids level. Some water-borne systems can be mixed with reactive monomers and catalyzed to form more complex resins. Some can be further crosslinked by the use of a crosslinking reagent, such as an aziridine, for example, which reacts with carboxyl groups.

A typical application of a water-borne resin and aqueous capsules follows. A volume of particles is centrifuged at low speed to separate excess water. After a given centrifugation process, for example 10 minutes at 60 x g, the capsules are found at the bottom of the centrifuge tube, while the water portion is at the top. The water portion is carefully removed (by decanting or pipetting). The mass of the remaining capsules is measured, and a mass of resin is added such that the mass of resin is between one eighth and one tenth of the weight of the capsules. This mixture is gently mixed on an oscillating mixer for approximately one half hour. After about one half hour, the mixture is ready to be coated onto the appropriate substrate.

The thermoset systems are exemplified by the family of epoxies. These binary systems can vary greatly in viscosity, and the reactivity of the pair determines the "pot life" of the mixture. If the pot life is long enough to allow a coating operation, capsules may be coated in an ordered arrangement in a coating process prior to the resin curing and hardening.

Thermoplastic polymers, which are often polyesters, are molten at high temperatures. A typical application of this type of product is hot-melt glue. A dispersion of heat-resistant capsules could be coated in such a medium. The solidification process begins during cooling, and the final hardness, clarity and flexibility are affected by the branching and molecular weight of the polymer.

Oil or solvent-soluble polymers are often similar in composition to the water-borne system, with the obvious exception of the water itself. The latitude in formulation for solvent systems is enormous, limited only by solvent choices and polymer solubility. Of considerable concern in solvent-based systems is the viability of the capsule itself - the integrity of the capsule wall cannot be compromised in any way by the solvent.

Radiation cure resins are generally found among the solvent-based systems. Capsules may be dispersed in such a medium and coated, and the resin may then be cured by a timed exposure to a threshold level of ultraviolet radiation, either long or short wavelength. As in all cases of curing polymer resins, final properties are determined by the branching and molecular weights of the monomers, oligomers and crosslinkers.

A number of "water-reducible" monomers and oligomers are, however, marketed. In the strictest sense, they are not water soluble, but water is an acceptable diluent at low concentrations and can be dispersed relatively easily in the mixture. Under these circumstances, water is used to reduce the viscosity (initially from thousands to hundreds of thousands centipoise). Water-based capsules, such as those made from a protein or polysaccharide material, for example, could be dispersed in such a medium and coated, provided the viscosity could be sufficiently lowered. Curing in such systems is generally by ultraviolet radiation.

## Claims

1. A process for forming a pattern in an organic semiconductor film (20) disposed on a substrate (10), the process being **characterized by** providing, through a printing or stamping process, a solvent (100) in contact with selected portions (21; 21') of the organic semiconductor film (20), the solvent (100) dissolving the selected portions (21; 21') of the organic semiconductor film (20), and the solvent being evaporated after dissolving the selected portions (21; 21') of the organic semiconductor film whereby the organic semiconductor redeposits as the solvent dries such that a property of the selected portions (21; 21') differs from that of the remaining portions of the organic semiconductor film (20).

2. A process according to claim 1 **characterized by** providing at least one of a conductive element and an insulative element to provide a circuit.

3. A process according to claim 1 **characterized in that** the solvent (100) is applied with a gelling agent.

4. A process according to any one of the preceding claims **characterized by** providing the solvent (100) through a screen printing process.

5. A process according to any one of the preceding claims **characterized in that** the organic semiconductor layer (20) comprises poly(alkylthiophene) and the solvent (100) comprises one of chloroform, toluene, and xylene.

## Patentansprüche

1. Verfahren zum Bilden eines Musters in einem auf einem Substrat (10) angeordneten organischen Halbleiterfilm (20), wobei das Verfahren **gekennzeichnet ist durch** Bereitstellen **durch** ein Druck- oder Prägeverfahren eines Lösungsmittels (100) in Kontakt mit ausgewählten Abschnitten (21; 21') des organischen Halbleiterfilms (20), wobei das Lösungsmittel (100) die ausgewählten Abschnitte (21; 21') des organischen Halbleiterfilms (20) auflöst und das Lösungsmittel verdampft wird, nachdem es die ausgewählten Abschnitte (21; 21') des organischen Halbleiterfilms aufgelöst hat, wodurch sich der organische Halbleiter wieder abscheidet, wenn das Lösungsmittel trocknet, so dass sich eine Eigenschaft der ausgewählten Abschnitte (21; 21') von jenen der restlichen Abschnitte des organischen Halbleiterfilms (20) unterscheidet.

2. Verfahren nach Anspruch 1, **gekennzeichnet durch** Bereitstellen eines leitfähigen Elements und/oder eines isolierenden Elements, um einen Schaltkreis bereitzustellen.

3. Verfahren nach Anspruch 1, **dadurch gekennzeichnet, dass** das Lösungsmittel (100) mit einem Geliermittel aufgebracht wird.

4. Verfahren nach einem der vorhergehenden Ansprüche, **gekennzeichnet durch** das Bereitstellen des Lösungsmittels (100) **durch** ein Siebdruckverfahren.

5. Verfahren nach einem der vorhergehenden Ansprüche, **dadurch gekennzeichnet, dass** die organische Halbleiterschicht (20) Poly(alkylthiophen) aufweist und das Lösungsmittel (100) eines von Chloroform, Toluol und Xylol aufweist.

## Revendications

1. Procédé pour former un motif dans un film semi-conducteur organique (20) disposé sur un substrat (10), le procédé étant **caractérisé par** l'application, par un procédé d'impression ou d'estampage, d'un solvant (100) en contact avec des parties sélectionnées (21 ; 21') du film semi-conducteur organique (20), le solvant (100) dissolvant les parties sélectionnées (21 ; 21') du film semi-conducteur organique (20), et le solvant étant évaporé après avoir dissous les parties sélectionnées (21 ; 21') du film semi-conducteur organique, d'où il résulte que le semi-conducteur organique se redépose lorsque le solvant sèche, de telle sorte qu'une propriété des parties sélectionnées (21 ; 21') diffère de celle des parties restantes du film semi-conducteur organique (20).

2. Procédé selon la revendication 1 **caractérisé par** l'adjonction d'un élément conducteur et/ou d'un élément isolant pour obtenir un circuit.

3. Procédé selon la revendication 1 **caractérisé en ce que** le solvant (100) est appliqué avec un gélifiant.

4. Procédé selon l'une quelconque des revendications précédentes **caractérisé par** l'application du solvant (100) par un procédé de sérigraphie.

5. Procédé selon l'une quelconque des revendications précédentes **caractérisé en ce que** la couche semiconductrice organique (20) comprend un poly(alkyl-thiophène) et le solvant (100) comprend du chloroforme ou du toluène ou du xylène.
